# EUROPEAN PATENT APPLICATION

(11) **EP 1 139 137 A2**
(43) Date of publication of application: **04.10.2001**
(21) Application number: 01302578.8
(22) Date of filing: 20.03.2001
(51) Int. Cl.: G02B 7/00, G02B 27/14, G02B 27/10

(54) **Light tap on optical sub-assembly**

(30) Priority: 20.03.2000 US 531264
(71) Applicant: Agere Systems Optoelectronics Guardian Corporation, Orlando, Florida 32819-8698 (US)
(72) Inventor: Bylsma, Richard Bendicks, Allentown, PA 18103 (US); Rinaudo, Dominic Paul, Blandon, PA 19510 (US); Shakespeare, Walter Jeffrey, Macungie, PA 18062 (US)
(74) Representative: Perkins, Sarah

(57) **Abstract**

An apparatus and method for providing multiple optical components with an individual laser light signal provided from one laser light source is disclosed. The apparatus (300) and method provide for the use of a mount (308) for a first optical component (106), which allows a portion of the laser light signal provided from the one laser source (102) to be received by the first optical component (106). The remainder of the laser light signal travels beyond the first optical component (106) and is received by a second optical component (202). The resultant individual signals are constructed without the use of a beam splitter.

## Description

### BACKGROUND OF THE INVENTION

### I. FIELD OF THE INVENTION

The present invention relates generally to laser light systems. More specifically, the present invention relates to an apparatus and method which provide laser light from a single laser light source to multiple laser light components without the use of a beam splitter.

### II. DESCRIPTION OF THE RELATED ART

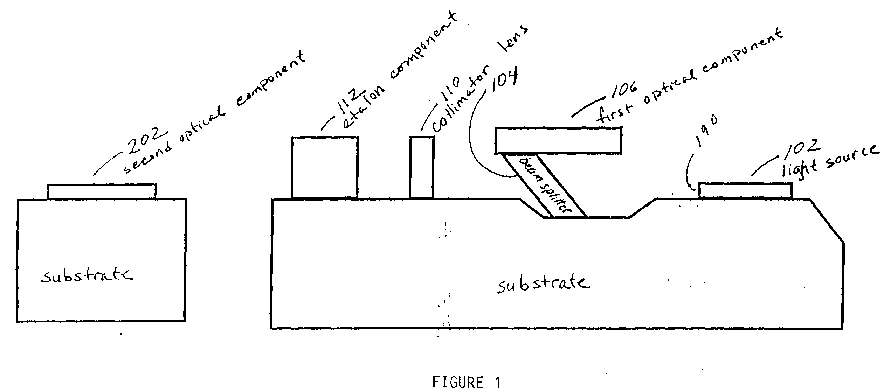

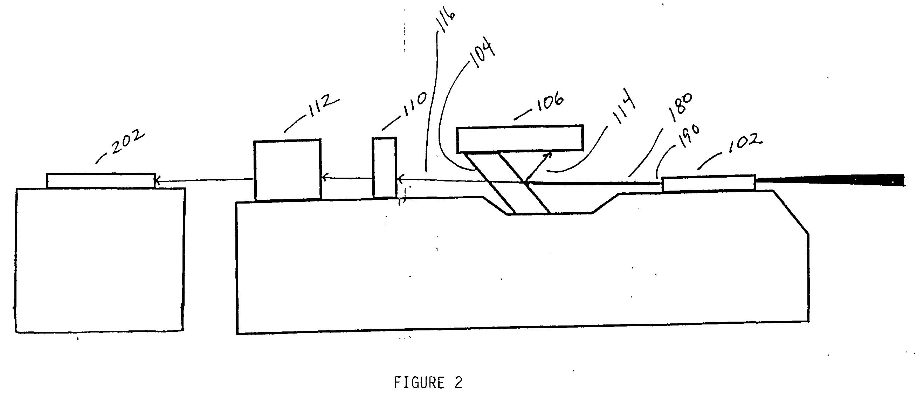

Laser light signals are increasingly being used as communication links for the transmission of data and voice signals. These laser light signals must be constantly monitored to ensure that proper light intensity is illuminated and the proper wavelength is maintained. Photo detectors and other optical components, such as etalon components, may be used to monitor the laser light from the backface of a laser source to determine the intensity and wavelength of the signal radiating from the frontface of the laser light source. These multiple components each require an unmodified laser light signal which typically requires the initial laser beam to be split by a beam splitter. As illustrated in Fig. 1, a first optical component 106 is physically separated from a second optical component 202. As shown in Fig. 2, the first and second optical components 106, 202, are used to monitor the laser light from the backface 190 of the light source 102. However, since the first and second optical components 106, 202 each require an independent unmodified laser light signal, a beam splitter 104 is used to create resultant laser light signals 114, 116. Moreover, components which pass the light signal substantially unmodified, such as a collimating lens (which collimates the light signal but doesn't change its properties), or etalon components may be placed before a second optical component 202. The use of a beam splitter increases costs, manufacturing time and adds one more component, which is susceptible to failure, to the system.

### SUMMARY OF THE INVENTION

The present invention provides an apparatus and method which delivers a laser light signal, originating from one laser light source, to multiple optical components without passing the laser light signal through a beam splitter. Ideally, the multiple optical components are at different distances from the laser light source.

Using a standard optical sub-assembly ("OSA''), a first optical component, which normally is bonded over an etched reflective cavity, is raised above the OSA substrate surface with a mounting support. A portion of the laser light signal is received by the first optical component. The remaining portion of the laser light passing under the first optical component is collimated through a lens and passed onto a second optical component. Therefore the second optical component can receive the other portion of the laser light without the use of a beam splitter.

The present invention eliminates the need for a beam splitter. It also provides a compact solution to obtain multiple laser light paths from a single laser light source.

### BRIEF DESCRIPTION OF THE DRAWINGS

The foregoing and other advantages and features of the invention will become more apparent from the detailed description of preferred embodiments of the invention which are provided below with reference to the accompanying drawings in which:
FIG. 1 is a side view of an optical sub-assembly employing a beam splitter;
FIG. 2 is a side view of an optical sub-assembly employing a beam splitter with laser light paths illustrated;
FIG. 3 is a side view of an optical sub-assembly implementing a raised first optical component in accordance with one embodiment of the present invention;
FIG. 4 is a front view of a first optical component residing on top of the mounting support of FIG. 3 in accordance with a first embodiment of the mounting support;
FIG. 5 is a front view of a first optical component residing on top of the mounting support of FIG. 3 in accordance with a second embodiment of the mounting support;
FIG. 6 is a side view of the optical sub-assembly of FIG. 3 with laser light paths;
FIG. 7 is a side view of an optical sub-assembly implementing a raised first optical component in accordance with a second embodiment of the present invention;
FIG. 8 is a side view of the optical sub-assembly of FIG. 7 with laser light paths;
FIG. 9 is a side view of the optical sub-assembly of FIG. 8 with an additional optical component and mounting support;
FIG. 10 is a side view of an optical sub-assembly implementing a lowered first optical component and a raised third optical component in accordance with a third embodiment of the present invention; and
FIG. 11 is a side view of the optical sub-assembly of FIG. 10 with laser light paths.

### DETAILED DESCRIPTION OF PREFERRED EMBODIMENTS

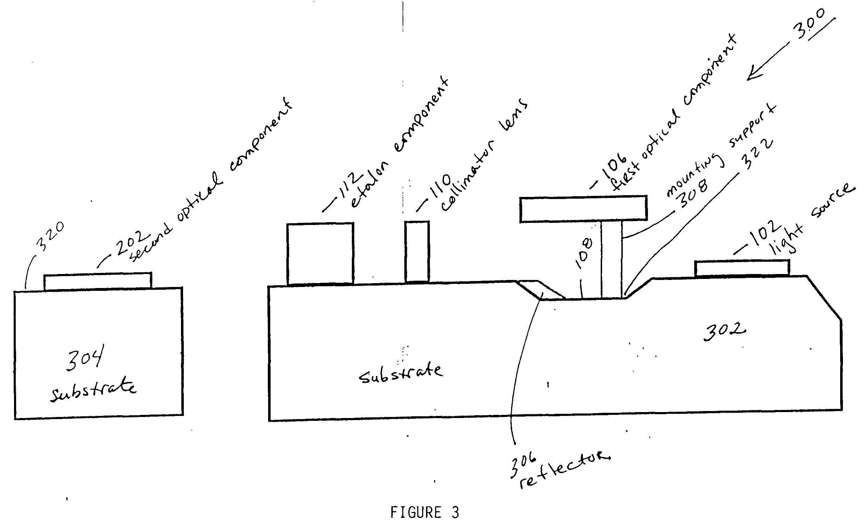

Referring now to the drawings, where like reference numerals designate like elements, there is shown in FIG. 3 a system 300 for providing laser light from a single laser light source 102 to a first and second optical component 106, 202. The system 300 comprises two substrates 302, 304. The first substrate 302 includes the single laser light source 102, a first optical component 106, a reflector 306, a collimator lens 110, and an etalon component 112. The first optical component 106 is a photo detector in the present embodiment, but may be any type of optical component. The second substrate 304 includes a second optical component 202 affixed to the top side 320 of the second substrate 304. The photo detector 106 is raised above the top surface 322 of the first substrate 302 by a positioner 308. The positioner 308 does not in any way obstruct, bend or modify the laser light signal 326 emanating from the single laser light source 102. The positioner in the embodiment of Fig. 3 is a mounting support 308. The mounting support 308 may be composed of a ceramic material, ceramic with wrap around metallization, glass, or glass with an integrated lens. A ceramic with wrap around metallization forming a conductive lead is the preferred mounting support 308 construction because the current output from photo detector 106 can be transmitted to the substrate surface 322 for analysis of the laser light intensity without the need for any additional conductive material or interface.

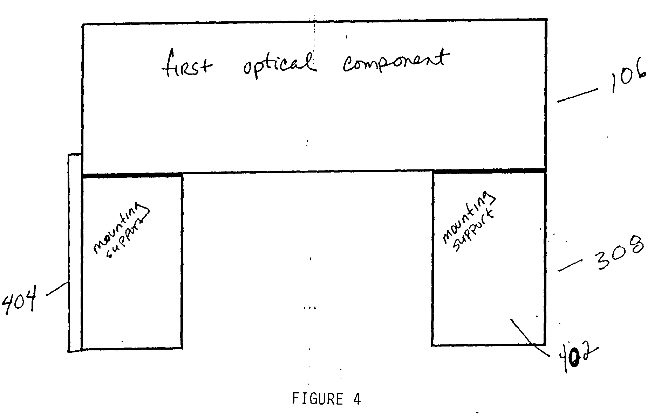

Fig. 4 illustrates the mounting support 308 composed of a non-transparent material, such as ceramic, where the mounting support 308 may feature two or more legs 402 to raise the first photo detector 106 off of the first substrate's top surface 322. The mounting support 308 of Fig. 4 is affixed to the first substrate 302 in either the etched cavity 108 or laterally outside of the etched cavity 108.

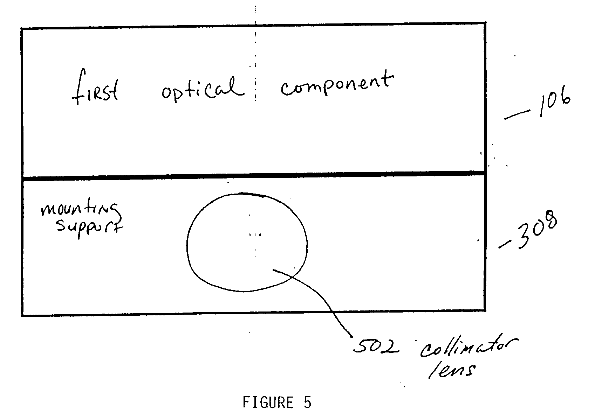

Fig. 5 illustrates another embodiment of the mounting support 308 where the mounting support is composed of a material transparent to laser light, such as glass. In this embodiment the mounting support 308 fully supports all the surface area of the photo detector 106 as shown in Fig 5. In addition, a lens, for example, a collimating lens 502 may be incorporated into the transparent mounting support 308.

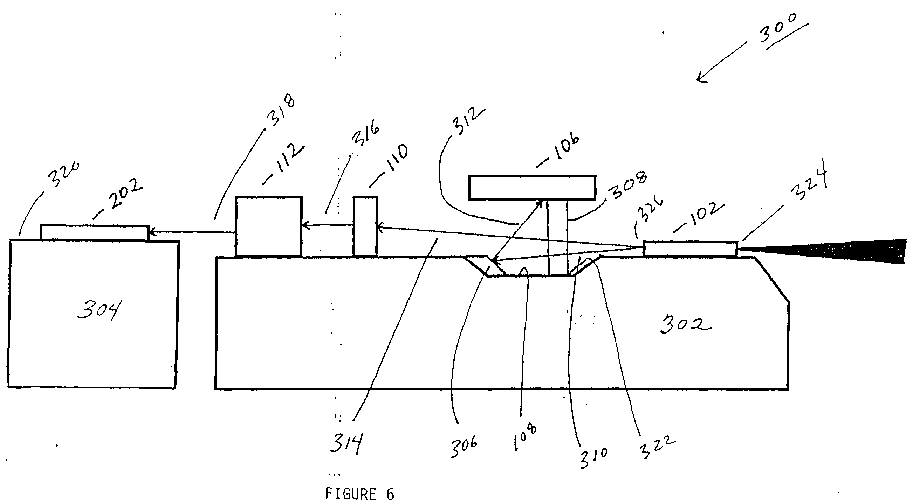

In operation, as depicted in Fig. 6, the single laser light source 102 emits a laser light signal 310 which propagates across the first substrate 302 and partially shines into an etched cavity 108 containing a reflector 306. The reflector 306 is angled such that the portion of the initial laser light which shines into the etched cavity 108 is reflected upwards to focus on the photo detector 106. A preferred angle would be 45 degrees, which would provide ample reflections with minimal dissipation of the signal. The photo detector 106 measures the intensity of the laser light signal 312 and sends a signal to the substrate surface 322, representing the intensity of the laser light at the backface 326 of the laser light source 102. This signal is used to determine the laser light intensity at the frontface 324 of the laser light source 102. For example, if 5 percent of the total signal is emitted from the backface 326 of the laser light source 102, and 20 percent of this is absorbed in the photo detector 106, the resulting intensity measured, in terms of current output from the photo detector 106, multiplied by 95, yields the laser light intensity at the frontface 324 of the laser light source 102. (This example assumes that 100 percent of the 20 percent backface laser light 326, 1 percent of the total signal, hits the photo detector 106. Therefore, since the measured intensity is 1 percent of the total signal, the laser light intensity at the frontface 324 is 95 fold that of the measured intensity.)

The remaining portion 314 of the initial laser light signal 326 continues to propagate in its initial direction and is received by a collimating lens 110. The collimating lens 110 collimates the portion 314 of the initial laser light signal 326 it received and passes the collimated signal 316 onto the etalon component 112. The etalon component 112 assists the system 300 by determining which wavelength is being used and controls the system 300 to maintain wavelength separation between signals using conventional control techniques. The etalon component 112 is particularly important in modern laser systems employing dense wavelength division multiplexing (DWDM). The etalon component 112 end product signal 318 is passed onto the second optical component 202, which resides on the second substrate 304. If a glass mounting support 308, see Fig. 5, is used, a collimating lens 502 can be incorporated therein, in which case a separate collimating lens 110 may be omitted from the first substrate 302. However, any mounting support 308 not containing conductive material will preferably include of one or more conductive leads from the photo detector 106 to the first substrate surface 302. One such conductive lead 404, is shown in Fig. 4. The one or more conductive leads 404 will carry the signal from the photo detector 106 to the first substrate surface 322 for analysis to derive signal intensity at the frontface 324 of the laser light source 102. In this example 302 and 304 are different substrates, but could be the same substrate.

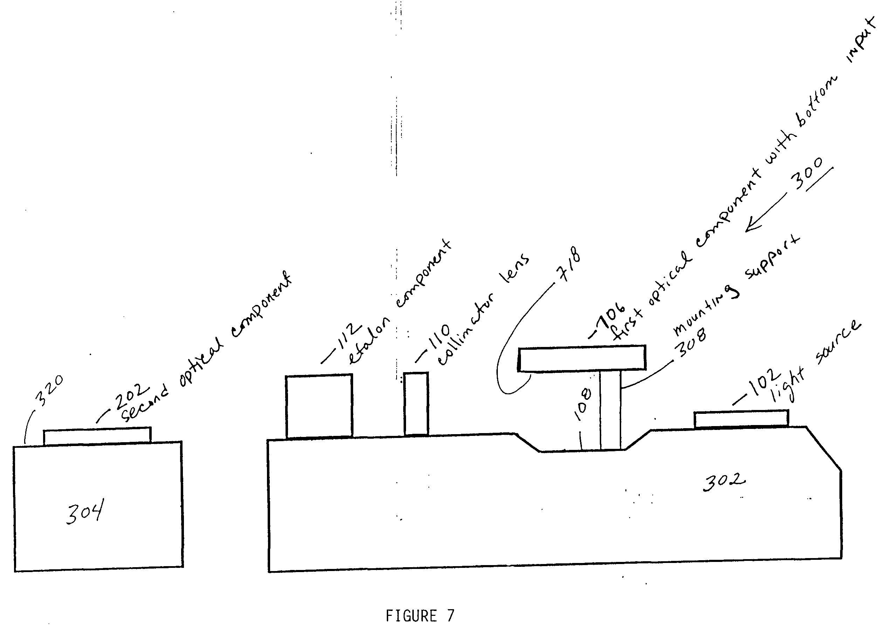

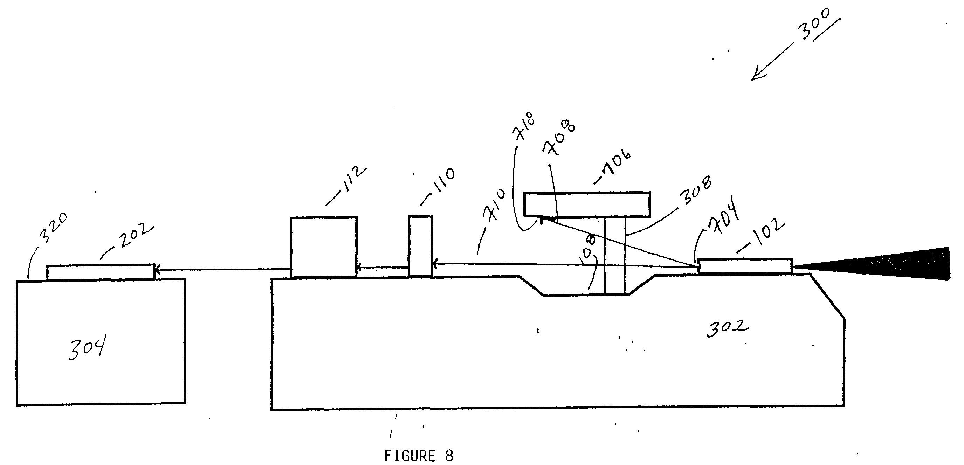

In another embodiment, as shown in Figs. 7 and 8, the invention may be practiced with a raised first optical component 706 without the use of a reflector. In such a case the first optical component 706 has an optical input 718 on the bottom surface of the first optical component 706 to receive a portion 708 of the laser light signal 704 without bending or reflecting the original laser light signal 704. Another portion 710 of the laser light signal 704 is passed on in a matter similar to the laser light signal 314 of Fig. 6.

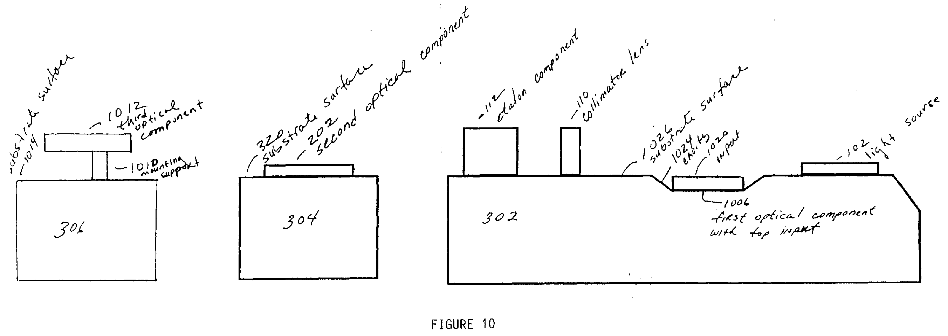

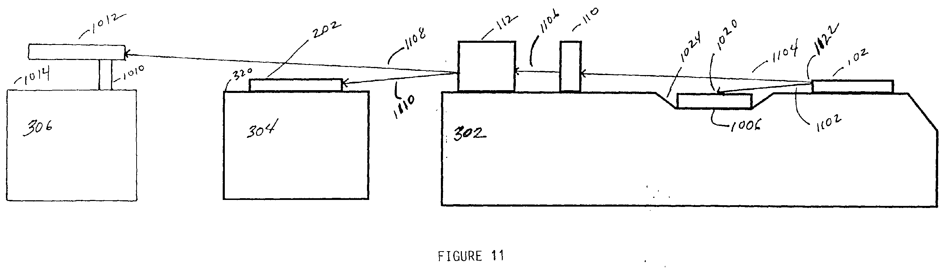

In yet another embodiment, as shown in Figs. 10 and 11, the invention may be practiced with a lowered first optical component 1006 without the use of a reflector. In such a case the positioner 1024 may be a cavity 1024 in which the first optical component 1006 resides. In this embodiment the first optical component 1006 has an optical input 1020 on the top surface to receive a portion 1102 of the laser light signal 1122 without bending or reflecting the original laser light signal 1122. Another portion 1104 of the laser light signal 1122 is passed on in a matter similar to the laser light signal 314 of Fig. 6.

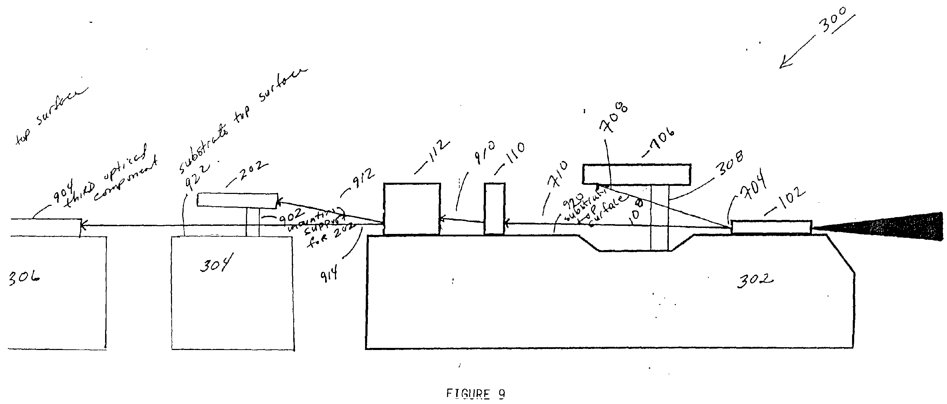

This invention may be practiced with a variety of materials used to form the positioner. In addition, optical components in excess of two may be used by employing multiple positioners in the form of mounting supports of descending heights with each successive optical component. This is illustrated in Fig. 9, where three optical components 706, 202, 904 each receive a portion of the initial laser light 704. This is accomplished by positioning each respective optical component 706,202, 904 at a different height using a mounting support 308, 902, where the first optical component 706 is raised by mounting support 308 above the substrate top surface 920. The second optical component 202 is also raised by a mounting support 902, which is shorter than mounting support 308, above the substrate top surface 922. The third optical component 904 rests on top of the substrate 924. Since the optical components 706, 202, 904 are at different heights, each can receive a portion of the initial laser light 704. Moreover a combination of lowered optical components as well as raised optical components may also be utilized. The configuration is illustrated in Fig. 11, where the first optical component 1006 is positioned below the substrate top surface 1026 by a positioner in the form of a cavity 1024. The second optical component 202 resides at a higher elevation on substrate 304 top surface 320. The third optical component 1012 is then raised above the substrates 306 top surface 1014 by a positioner in the form a mounting support 1010. This configuration also provides each optical component 1006, 202, 1012 with a portion of the initial laser light 1122.

The scope of the present invention is not to be considered as limited by the specifics of the particular structures which have been described and illustrated, but is only limited by the scope of the appended claims.

## Claims

1. An apparatus for providing a laser light signal to multiple optical components, said apparatus comprising:
a laser light source for producing a laser light signal; and
a first optical component and a second optical component, said first and second optical components arranged to substantially simultaneously receive said laser light signal from said laser light source without passing said laser light signal through a beam splitter.

2. The apparatus of claim 1 further comprising a mounting support for raising said first optical component which allows said first optical component to receive at least a portion of said laser light signal and which allows at least one other portion of said laser light signal to pass under said first optical component.

3. The apparatus of claims 1 or 2 further comprising a reflector in a cavity which reflects at least a portion of said laser light signal passing under said first optical component to said first optical component.

4. The apparatus of claim 1 further comprising a cavity for said first optical component which allows said first optical component to receive at least a portion of said laser light signal and which allows at least one other portion of said laser light signal to pass over said first optical component.

5. The apparatus of any one of the preceding claims, wherein said first optical component comprises a first photo detector.

6. The apparatus of any one of the preceding claims, wherein said second optical component comprises a second photo detector.

7. The apparatus of claims 2 or 4 further comprising an etalon component to monitor the wavelength of said at least one other portion of said laser light signal.

8. The apparatus of claims 2 or 4 further comprising a collimating lens to receive said at least one other portion of said laser light signal passing said first optical component.

9. The apparatus of claim 2, wherein said mounting support comprises ceramic material.

10. The apparatus of claim 9, wherein said mounting support further comprises an outer metallization layer on said ceramic material.

11. The apparatus of claim 2, wherein said mounting support comprises transparent material which allows said at least one other portion of laser light to pass therethrough.

12. The apparatus of claim 11, wherein said transparent material comprises glass.

13. The apparatus of claim 12, wherein said glass comprises a lens.

14. The apparatus of claim 9 further comprising a conductive lead contacting said first optical component.

15. The apparatus of claim 1 further comprising a positioner to allow said first optical component to receive at least a portion of said laser light signal and to allow said second optical component to receive at least one other portion of said laser light signal, where said laser light signal is a single laser beam.

16. The apparatus of claim 1 further comprising a positioner such that said first and/or said second optical component directly receives a portion of said laser light source.

17. The apparatus of claim 3 further comprising a positioner such that said first or said second optical component receives an unobstructed reflected signal from said laser light signal reflected off of said reflector.

18. The apparatus of claim 1, wherein said first laser light source comprises an output for a signal depicting the light signal intensity received.

19. The apparatus of claim 1, wherein said laser light signal is provided from the backface of said laser light source.

20. A method for providing a laser light signal to multiple optical components, said method comprising:
transmitting a laser light signal from a laser light source;
receiving at least a portion of said laser light signal at a first optical component; and
receiving at least one other portion of said laser light signal at a second optical component, said transmitted laser light signal being received by said first and second optical components without passing through a beam splitter.

21. The method of claim 20, further comprising reflecting said at least a portion of said laser light signal up to said first optical component after said step of transmitting said laser light signal.

22. The method of claim 20, wherein said laser light signal is received by said first and/or second optical component directly from said laser light source.

23. The method of claim 20, wherein said at least one other portion of said laser light signal is passed through a collimating lens prior to arriving at said second optical component.

24. The method of claim 20, wherein said at least one other portion of said laser light signal is passed through an etalon component prior to arriving at said second optical component.

25. The method of claim 20 further comprising monitoring the wavelength of said at least one other portion of said laser light signal provided from said laser light source.

26. The method of claim 20, wherein said first optical component detects the intensity of at least one of said portions of said laser light signal.

27. The method of claim 26 further comprising controlling the intensity of said at least one of said portions of said laser light signal provided from said laser light source based upon the output received from said first optical component.

28. The method of claim 20, wherein said laser light signal is sent from the backface of said laser light source.
